# FASCICULE DE BREVET EUROPEEN

(11) **EP 4 492 950 B1**
(45) Date de publication et mention de la délivrance du brevet: **17.06.2026**
(21) Numéro de dépôt: 24187026.0
(22) Date de dépôt: 08.07.2024
(51) Int. Cl.: H10B 63/00, H10N 70/20

(54) **DISPOSITIF ÉLECTROCHIMIQUE DE STOCKAGE DE CHARGES ET MÈTHODE DE FABRICATION ET PROCÉDÉ DE STOCKAGE DE CHARGES**
ELEKTROCHEMISCHE LADUNGSSPEICHERVORRICHTUNG UND HERSTELLUNGSVERFAHREN UND EIN VERFAHREN ZUR SPEICHERUNG VON ELEKTRISCHEN LADUNGEN
ELECTROCHEMICAL CHARGE STORAGE DEVICE AND FABRICATION METHOD AND A METHOD OF STORING CHARGES

(30) Priorité: 10.07.2023 FR 2307354
(43) Date de publication de la demande: 15.01.2025
(73) Titulaire: Commissariat à l'Energie Atomique et aux Energies Alternatives, 75015 Paris (FR)
(72) Inventeur: OUKASSI, Sami, 38054 GRENOBLE CEDEX 09 (FR); HIRTZLIN, Tifenn, 38054 GRENOBLE CEDEX 09 (FR); MELFI, Massimiliano, 38054 GRENOBLE CEDEX 09 (FR); NGUYEN, Ngoc-Anh, 38054 GRENOBLE CEDEX 09 (FR); VIANELLO, Elisa, 38054 GRENOBLE CEDEX 09 (FR)
(74) Mandataire: Cabinet Camus Lebkiri

(56) Documents cités:
- WO-A1-2019/210156
- US-A1- 2017 323 945
- BOLUN WANG ET AL: "Bioelectronics-Related 2D Materials Beyond Graphene: Fundamentals, Properties, and Applications", ADVANCED FUNCTIONAL MATERIALS, WILEY - V C H VERLAG GMBH & CO. KGAA, DE, vol. 30, no. 46, 6 September 2020 (2020-09-06), pages n/a, XP072411923, ISSN: 1616-301X, DOI: 10.1002/ADFM.202003732

## Description

### DOMAINE TECHNIQUE DE L'INVENTION

Le domaine technique de l'invention est celui des composants de stockage de charges, en particulier des composants électrochimiques de stockage de charges.

En particulier, l'invention concerne un dispositif électrochimique de stockage de charges pouvant être utilisé dans des circuits neuromorphiques.

### ARRIERE-PLAN TECHNOLOGIQUE DE L'INVENTION

L'utilisation d'algorithmes d'intelligence artificielle pour un large éventail d'applications a explosé ces dernières années. Ces algorithmes nécessitent souvent des architectures dites neuromorphiques, qui visent à imiter le traitement synaptique qui se produit dans le cerveau humain. Ainsi, les architectures (ou circuits) neuromorphiques sont des circuits électroniques conçus pour émuler le comportement des neurones biologiques et des réseaux neuronaux.

Les architectures neuromorphiques, comme les unités de traitement résistives (RPU, pour « Resistive Processing Unit » en anglais) d'IBM^{™}, sont basées en partie sur des dispositifs de mémoires résistives qui utilisent un réseau d'éléments croisés pour obtenir de bonnes performances en termes de densité de mémoire, d'efficacité énergétique et de vitesse, en réduisant le mouvement des données pendant le calcul et en tirant parti d'états analogiques à plusieurs niveaux. De telles unités de traitement résistives peuvent accélérer la formation de réseaux neuronaux profonds en utilisant peu d'énergie. Il est en effet possible de reproduire le fonctionnement d'un neurone biologique en utilisant un réseau de mémoires résistives associées à des poids synaptiques respectifs.

Les dispositifs existants basés sur des filaments conducteurs ou sur des matériaux à changement de phase souffrent d'un bruit d'écriture excessif. Dans ces dispositifs, il est difficile de réduire le bruit et d'abaisser la tension de commutation tout en assurant la conservation des données à long terme, ce qui représente une limitation importante en termes de précision, d'efficacité énergétique et d'évolutivité de ces dispositifs. Pour mettre en œuvre des systèmes neuromorphiques efficaces, il est donc préférable d'utiliser des éléments de mémoire résistifs qui commutent à l'aide d'un mécanisme différent de celui utilisé dans les dispositifs à formation de filament ou à changement de phase.

C'est pourquoi, récemment, une nouvelle catégorie de composants a été étudiée pour ces applications neuromorphiques : le transistor ionique, qui peut être utilisé comme transistor synaptique. Le fonctionnement du transistor ionique est basé sur le déplacement d'ions entre la source et le drain, qui permet de modifier la valeur de conductance du transistor. Un tel transistor est notamment décrit dans l'article de Nguyen et al. « An Ultralow Power LixTiO2-Based Synaptic Transistor for Scalable Neuromorphic Computing », publié dans Advanced Electronic Materials en 2022. Les documents WO 2019/210156 A1 et US 2017/323945 A1 sont des autres exemples de l'art antérieur.

Le transistor ionique peut avantageusement être dans une pluralité d'états (plusieurs dizaines) non volatils, chaque état correspondant à une valeur de conductance respective. Dans le cadre des applications neuromorphiques, les valeurs de conductance du transistor correspondent aux différentes valeurs de poids synaptiques. Toutefois, il existe un besoin pour lire facilement ces valeurs de poids synaptiques, afin de les utiliser dans des applications neuromorphiques.

### RESUME DE L'INVENTION

L'invention offre une solution au problème évoqué précédemment, en proposant un dispositif électrochimique de stockage de charges (ou simplement par la suite « dispositif électrochimique de stockage ») comprenant un transistor ionique et une capacité ionique montés en série. Les transistors ioniques peuvent être mis dans une multitude de niveaux de conductance, et nécessitent une très faible quantité d'énergie pour passer d'un niveau de conductance à un autre. En outre, les capacités ioniques présentent des grandes densités de capacité. Cette propriété rend possible leur connexion en série avec des transistors ioniques. La mise en série d'un transistor ionique et d'une capacité ionique simule de manière efficace les connexions synaptiques et la simulation du potentiel membranaire des neurones, ce qui en fait une approche viable pour la conception de systèmes neuromorphiques complexes et puissants.

En outre, il est possible de fabriquer, sur un même substrat, un transistor ionique et une capacité ionique en série, en mutualisant une grande partie des étapes de fabrication des deux composants. Cela permet d'obtenir un dispositif compact dont la fabrication est relativement simple et peu coûteuse.

Un aspect de l'invention concerne ainsi un dispositif électrochimique de stockage de charges comprenant un transistor ionique et une capacité ionique,

le transistor ionique comprenant :
- une couche formant un réservoir d'ions, appelée couche réservoir ;
- une électrode de source en contact avec une partie de la couche réservoir ;
- une électrode de drain en contact avec une autre partie de la couche réservoir, l'électrode de drain et l'électrode de source étant physiquement séparées l'une de l'autre, l'électrode de source et l'électrode de drain étant chacune dans un matériau électriquement conducteur ; et
- une électrode de grille dans un matériau électriquement conducteur, l'électrode de grille étant séparée de la couche réservoir par une couche conductrice ionique dans un matériau conducteur ionique et diélectrique, la couche conductrice ionique étant en contact avec l'électrode de source et avec l'électrode de drain ;

la capacité ionique comprenant deux électrodes, chacune des deux électrodes étant dans un matériau électriquement conducteur, la capacité ionique comprenant une couche conductrice ionique séparant les deux électrodes de la capacité ionique, la couche conductrice ionique de la capacité ionique étant dans un matériau conducteur ionique et diélectrique ;
dans lequel le transistor ionique et la capacité ionique sont connectés électriquement en série.

La couche réservoir est une couche dans un matériau comprenant des ions d'un certain type (par exemple Li+). La couche réservoir peut être dans un matériau dit « matériau d'insertion d'ions », ou « composé d'insertion » ou « matériau d'intercalation d'ions », i.e. un matériau qui permet la pénétration d'un certain type d'ions, sans altération de ses propriétés. Dans la suite, la couche réservoir est aussi appelée « couche de canal » ou « couche de matériau d'insertions d'ions ». Il est noté que, ci-dessus, un « matériau conducteur ionique » désigne un matériau conducteur pour les mêmes ions que ceux de la couche réservoir.

Lorsque la capacité ionique a une structure « empilée » sur le substrat (dans le sens ou les électrodes s'étendent le long d'une direction qui correspond à la direction principale du substrat), la terminologie « électrode supérieure / électrode inférieure » peut être utilisée pour les électrodes de la capacité ionique. L'électrode inférieure correspond à l'électrode la plus proche du substrat, tandis que l'électrode supérieure correspond à l'électrode la plus éloignée du substrat.

Par « connectés électriquement en série », il est entendu que l'une des électrodes de la capacité est connectée à l'une des électrodes (appelée par la suite « électrode inférieure » par souci de simplification) parmi l'électrode de source et l'électrode de drain du transistor. Ainsi, l'électrode de source du transistor, le canal du transistor, l'électrode de drain du transistor et l'électrode inférieure de la capacité sont connectés. En d'autres termes, le courant de sortie du transistor correspond au courant d'entrée dans la capacité.

En connectant un transistor ionique et une capacité ionique en série, il est possible de lire la valeur de la conductance du transistor ionique (et donc des poids synaptiques, dans un système neuromorphique) à partir du temps de charge de la capacité ionique. Il est noté que l'utilisation d'une capacité ionique a son importance. Par exemple, il n'est pas envisageable de la remplacer par un condensateur diélectrique du fait de la grande plage de valeurs possibles de conductance du transistor ionique, car cela entraînerait une dégradation du condensateur diélectrique. En outre, la réalisation d'un circuit connectant un transistor ionique et une capacité ionique peut être avantageusement simplifiée car ces composants utilisent des couches communes de matériaux. Ainsi, certaines étapes de fabrication peuvent être mutualisées.

Il est noté que le transistor ionique (ou transistor synaptique) et la capacité ionique (ou condensateur ionique, ou supercondensateur ionique) sont deux composants connus de l'état de la technique. Toutefois, dans l'état de la technique, la capacité ionique est utilisée comme élément électrochimique de stockage à part entière et n'est pas connectée en série à un transistor ionique pour pouvoir lire les valeurs de conductance de celui-ci.

Dans des modes de réalisation de l'invention, la couche conductrice ionique du transistor ionique et la couche conductrice ionique de la capacité ionique sont dans un même matériau conducteur ionique et diélectrique.

Cette propriété permet avantageusement de déposer mutuellement la couche conductrice ionique du transistor ionique et la couche conductrice ionique de la capacité ionique. En particulier, ces deux couches conductrices ioniques peuvent être formées à partir d'une même couche déposée et structurée en surface d'un substrat sur lequel sont montées l'électrode de source, le canal et l'électrode de drain du transistor ainsi que l'électrode inférieure de la capacité ionique.

Par exemple, le matériau conducteur ionique et diélectrique peut être un oxynitrure de phosphore de lithium LiPON, un oxynitrure de lithium-silicium-phosphore LiSiPON, un sulfure de phosphore de germanium de lithium LGPS, un oxyde de lithium lanthane zirconium LiLaZrₓO_{y} ou un oxyde de lithium lanthane tantale LiLaTaOₓ.

Le LiPON peut être utilisé pour un transistor ionique et une capacité ionique fonctionnant à base d'ions lithium Li+ (i.e. dont le fonctionnement repose sur la circulation d'ions Li+). Dans ces modes de réalisation, le canal du transistor ionique peut être réalisé dans un matériau d'insertion d'ions Li+, par exemple un oxyde de métal de transition pouvant intercaler des ions Li+. Bien entendu, l'invention s'applique à d'autres ions porteurs de charges, par exemple des ions Na+, H+, K+, Cu+, etc.

Le matériau électriquement conducteur dans lequel sont réalisées les électrodes de la capacité ionique et/ou les électrodes de source, drain ou grille du transistor ionique peut être, par exemple, un parmi : titane (Ti), tungstène (W), molybdène (Mo), nickel (Ni) ou platine (Pt).

La couche réservoir peut être réalisée, par exemple, dans l'un des matériaux suivants : dioxyde de titane (TiO₂), dioxyde de cobalt et de lithium (LiCoO₂), niobate de lithium (LiNbOₓ), trioxyde de tungstène (WO₃), oxyde de vanadium (VOₓ), oxyde de nickel (NiOₓ), oxyde de manganèse (MnOₓ) - et de manière générale des oxydes de métaux de transition, disulfure de molybdène (MoS₂), graphène.

Dans des modes de réalisation, la couche réservoir et la couche conductrice ionique du transistor ionique sont dans un même matériau conducteur ionique et diélectrique.

Dans des modes de réalisation, la couche conductrice ionique du transistor ionique et la couche conductrice ionique de la capacité ionique peuvent avoir une même épaisseur.

Ainsi, ces deux couches conductrices ioniques peuvent être formées en déposant une unique couche d'épaisseur constante et en la structurant en deux parties distinctes, l'une correspondant à la couche conductrice ionique du transistor ionique et l'autre partie correspondant à la couche conductrice ionique de la capacité ionique.

Avantageusement, le transistor ionique et la capacité ionique peuvent être situés sur un même substrat, de manière monolithique.

Par « situés sur un même substrat », il est entendu que le transistor ionique et la capacité ionique sont intégrés sur une même plaque de substrat. Cela permet une co-intégration des deux composants en parallèle, avec des étapes de fabrication mutualisées. En particulier, au moins certaines couches sont issues d'une même couche de matériau déposée et structurée. On notera qu'on entend par « substrat » le substrat brut (i.e. un wafer de Si par exemple) mais aussi un substrat brut sur lequel seraient déposées une ou plusieurs couches semiconductrices ou isolantes. Par « monolithique », il est entendu « d'un seul bloc ». En d'autres termes, le transistor ionique et la capacité ionique sont intégrés sur le même substrat et forment un ensemble.

Par exemple, le transistor ionique et la capacité ionique peuvent être montés sur un même niveau du substrat.

En particulier, le substrat peut comprendre, sur un premier niveau, des composants de type CMOS, et, sur un deuxième niveau, le transistor ionique et la capacité ionique. Par exemple, la fabrication du transistor ionique et de la capacité ionique peut être faite en « Back End Of Line » sur un substrat intégrant des CMOS, sous réserve de respecter des températures maximales de l'ordre de 450°C.

Dans des modes de réalisation, le substrat peut comprendre un évidement, dans lequel au moins une partie de la capacité ionique est logée dans l'évidement. L'évidement peut être un trou borgne.

Cela permet d'augmenter la surface d'échange entre les électrodes inférieure et supérieure de la capacité ionique, et donc la valeur de la capacité.

Dans ces modes de réalisation, l'une des électrodes de la capacité ionique, appelée électrode inférieure, s'étend le long d'une surface interne de l'évidement, la couche conductrice ionique de la capacité ionique recouvre au moins partiellement l'électrode inférieure de la capacité ionique et l'autre électrode de la capacité ionique, appelée électrode supérieure, recouvre au moins partiellement la couche conductrice ionique de la capacité ionique.

Dans des modes de réalisation, l'électrode de source du transistor ionique, l'électrode de drain du transistor ionique et l'une des électrodes, appelée électrode inférieure, de la capacité ionique peuvent être dans un même matériau électriquement conducteur et avoir une même épaisseur.

Cette propriété rend possible une fabrication simplifiée de ces électrodes par dépôt et structuration d'une même couche de matériau électriquement conducteur.

En particulier, l'électrode inférieure de la capacité ionique et l'une des électrodes parmi l'électrode de drain et l'électrode de source du transistor ionique et peuvent être communes.

Par « communes », il est entendu que le dispositif comprend une couche « continue » (i.e. sans discontinuités, pour laquelle il n'y a pas d'interruption) qui joue à la fois le rôle d'électrode de drain / de source du transistor ionique et d'électrode inférieure de la capacité ionique. Par exemple, l'une des extrémités de la couche continue correspond à l'électrode de drain ou de source du transistor, et l'autre extrémité à l'électrode inférieure de la capacité.

En outre, l'électrode de grille du transistor ionique et l'autre électrode, appelée électrode supérieure, de la capacité ionique peuvent être dans un même matériau électriquement conducteur. Par exemple, ce matériau électriquement conducteur peut être (mais ce n'est pas obligatoire) le même matériau que celui de l'électrode de source du transistor ionique, l'électrode de drain du transistor ionique et l'électrode inférieure de la capacité ionique.

En particulier, l'électrode de grille du transistor ionique et l'électrode supérieure de la capacité ionique peuvent avoir une même épaisseur. Ainsi, ces deux électrodes peuvent être formées à partir d'un dépôt et structuration d'une unique couche de ce matériau électriquement conducteur.

Dans certains modes de réalisation, le dispositif peut comprendre une pluralité de transistors ioniques raccordés en parallèle, chaque transistor ionique de la pluralité de transistors ioniques étant raccordé en série avec la capacité ionique.

Par « raccordés en parallèle », il est entendu que les transistors ont une électrode de source et une électrode de drain communs.

Un autre aspect de l'invention concerne un circuit comprenant un dispositif électrochimique de stockage comme défini ci-avant, le circuit comprenant en outre un bloc comparateur connecté en série à une sortie de la capacité ionique, le bloc comparateur étant configuré pour déclencher un signal lorsqu'une tension aux bornes de la capacité ionique atteint une valeur de tension de référence.

Dans des modes de réalisation, le bloc comparateur comprend un amplificateur opérationnel recevant, sur une entrée, la tension aux bornes de la capacité ionique et, sur une autre entrée, la valeur de tension de référence, le signal étant déclenché lorsque la tension aux bornes de la capacité ionique atteint la valeur de tension de référence, le signal correspondant à une réponse d'une synapse artificielle.

En outre, le circuit peut comprendre des moyens pour déterminer un temps mis par la capacité ionique pour que la tension à ses bornes atteigne la tension de référence.

**Il** est ainsi possible de déterminer le temps de charge de la capacité ionique en fonction du temps écoulé entre la génération d'un courant circulant entre le transistor ionique et la capacité ionique et le déclenchement de l'événement, et d'en déduire une valeur (approximée) de la conductance du transistor ionique, ce temps de charge correspondant à un poids synaptique.

Un autre aspect de l'invention concerne un procédé de fabrication d'un dispositif électrochimique de stockage de charges comme défini précédemment. Ce procédé comprend successivement :
- dépôt, sur un substrat, d'une première couche de matériau électriquement conducteur, et structuration de ladite première couche de sorte à obtenir une première partie de la première couche et une deuxième partie de la première couche n'ayant aucun point de contact, la première partie de la première couche correspondant à une électrode parmi une électrode de source et une électrode de grille du transistor ionique, la deuxième partie de la première couche correspondant à l'autre électrode parmi l'électrode de source et l'électrode de drain du transistor ionique et à une première électrode parmi les deux électrodes de la capacité ionique ;
- dépôt de la couche réservoir, la couche réservoir étant en contact avec l'électrode de source et l'électrode de drain du transistor ionique ;
- dépôt d'une couche conductrice ionique dans un matériau conducteur ionique et diélectrique, et structuration de la couche conductrice ionique de sorte à obtenir une première partie de la couche conductrice ionique et une deuxième partie de la couche conductrice ionique n'ayant aucun point de contact, la première partie recouvrant la couche réservoir et étant en contact avec l'électrode de source et l'électrode de drain du transistor ionique, la deuxième partie recouvrant au moins partiellement la première électrode de la capacité ionique ; et
- dépôt d'une deuxième couche de matériau électriquement conducteur, et structuration de ladite deuxième couche de sorte à obtenir une première partie de la deuxième couche et une deuxième partie de la deuxième couche n'ayant aucun point de contact, la première partie de la deuxième couche recouvrant partiellement la première partie de la couche conductrice ionique et n'ayant aucun point de contact avec la première partie de la première couche et la deuxième partie de la première couche, la deuxième partie de la deuxième couche recouvrant au moins partiellement la deuxième partie de la couche conductrice ionique et n'ayant aucun point de contact avec la deuxième partie de la première couche, la première partie de la deuxième couche correspondant à l'électrode de grille du transistor ionique, la deuxième partie de la deuxième couche correspondant à une deuxième électrode parmi les deux électrodes de la capacité ionique, la deuxième électrode étant distincte de la première électrode.

Il est ainsi possible de fabriquer un dispositif électrochimique de stockage de façon monolithique sur un même substrat, en mutualisant certaines étapes pour fabriquer à la fois les éléments composant le transistor ionique et les éléments composant la capacité ionique. Ceci est rendu possible par le fait que le transistor ionique et la capacité ionique sont composés de couches de matériaux similaires. Il en résulte une simplicité de fabrication, et un dispositif électrochimique de stockage compact et adapté à des applications neuromorphiques.

En particulier, le dépôt d'au moins une couche parmi la première couche de matériau électriquement conducteur, la couche conductrice ionique et la deuxième couche de matériau électriquement conducteur peut être un dépôt conforme.

Par « dépôt conforme », il est entendu un dépôt épousant la surface sur laquelle la couche de matériau est formée et ayant une même épaisseur sur toute sa surface de dépôt.

Ainsi, une unique couche peut être déposée puis structurée pour former plusieurs éléments du dispositif électrochimique de stockage selon l'invention.

Enfin, l'invention concerne aussi un procédé de stockage de charges utilisant un dispositif électrochimique de stockage comme défini ci-dessus, comprenant :
- appliquer une tension au niveau de l'électrode de grille du transistor ionique, de sorte à fixer une valeur de conductance prédéfinie pour le transistor ionique ; et
- générer un courant circulant entre le transistor ionique et la capacité ionique, une valeur d'intensité du courant de sortie du transistor ionique correspondant à une valeur d'entrée du courant d'entrée de la capacité ionique.

L'invention et ses différentes applications seront mieux comprises à la lecture de la description qui suit et à l'examen des figures qui l'accompagnent.

### BREVE DESCRIPTION DES FIGURES

D'autres caractéristiques et avantages de l'invention apparaîtront à la lecture de la description, qui peut être lue en regard des figures. Ces figures sont présentées à titre indicatif et nullement limitatif de l'invention.
[Fig. 1a], [Fig. 1b] Les Figures 1a et 1b représentent un transistor ionique de l'état de la technique.
[Fig. 2] La Figure 2 représente une capacité ionique de l'état de la technique.
[Fig. 3] La Figure 3 représente un exemple d'un système neuromorphique comprenant un élément électrochimique de stockage selon un mode de réalisation de l'invention.
[Fig. 4a], [Fig. 4b], [Fig. 4c], [Fig. 4d], [Fig. 4e], [Fig. 4f] Les Figures 4a à 4f illustrent des étapes d'un procédé de fabrication d'un élément électrochimique de stockage selon un mode de réalisation de l'invention.
[Fig. 5] La Figure 5 représente un exemple d'ordinogramme d'un procédé de fabrication d'un élément électrochimique de stockage selon un mode de réalisation de l'invention.
[Fig. 6] La Figure 6 représente un exemple d'ordinogramme d'un procédé de stockage de charges utilisant un élément électrochimique de stockage selon un mode de réalisation de l'invention.

### DESCRIPTION DETAILLEE

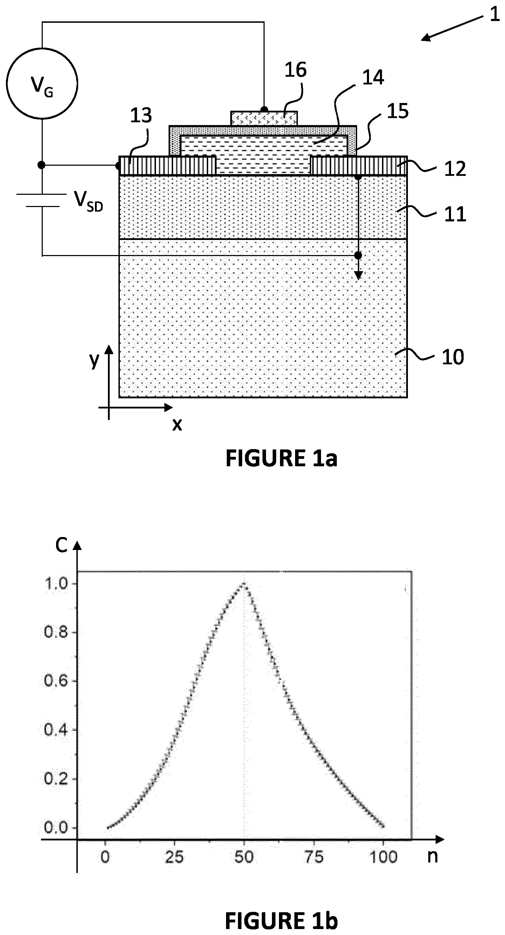

La Figure 1a représente un transistor ionique 1 selon l'état de la technique.

Le transistor ionique 1 est un transistor analogique monté sur un substrat 10, notamment en silicium Si, recouvert d'une couche 11 de matériau diélectrique (par exemple, du dioxyde de silicium SiO₂), qui comprend un canal 14 de conductivité électrique variable, une électrode de source 13 (aussi appelée simplement « source ») et une électrode de drain 12 (aussi appelée simplement « drain »). Il est noté que dans certains modes de réalisation l'ensemble formé par le substrat 10 et la couche 11 de diélectrique peut être remplacé par une couche unique de matériau diélectrique. Le drain 12 et la source 13 sont séparés l'un de l'autre par le canal 14, de sorte que le drain 12 et la source 13 n'ont aucun point de contact physique. Par exemple, le drain 12 et la source 13 peuvent être déposés sur deux portions d'une surface de la couche 11 de matériau diélectrique, les deux portions de la surface de la couche 11 de matériau diélectrique étant espacées l'une de l'autre de, par exemple, quelques dizaines de nanomètres. Le drain 12 et la source 13 sont dans un matériau électriquement conducteur. Le canal 14 est dans un matériau d'insertion d'ions. Il est noté que les électrodes de source et de drain peuvent être interchangées (en particulier, sur la Figure 1a, l'électrode 12 peut représenter la source et l'électrode 13 peut représenter le drain).

Le transistor ionique 1 comprend en outre une couche 15 d'un matériau à la fois conducteur ionique et diélectrique, séparant le canal 14 d'une électrode 16 appelée grille, positionnée à la surface supérieure de la couche 15 de matériau à la fois conducteur ionique et diélectrique. L'électrode de grille 16 (aussi appelée simplement « grille ») est dans un matériau électriquement conducteur. La couche 15 permet donc le transport d'ions entre le canal 14 et l'électrode de grille 16, mais bloque le transport des électrons. Il est entendu que la couche 15 est conductrice pour les mêmes ions que le matériau d'insertions d'ions composant le canal 14. Par exemple, si le canal 14 est dans un matériau permettant l'intercalation d'ions Li+, le matériau de la couche 15 est conducteur pour les ions Li+.

Le transistor ionique 1 peut être fabriqué en déposant (et en structurant) successivement les couches qui le composent (dépôt des couches formant le drain 12 et la source 13, puis dépôt de la couche 14 formant le canal, puis dépôt de la couche 15 de matériau conducteur ionique et diélectrique, et enfin dépôt de la couche 16 formant l'électrode de grille 16), par exemple par un procédé de lithographie (photolithographie ou lithographie électronique).

Le canal 14 est dans un matériau d'insertion d'ions, dont la conductivité électrique dépend de son niveau d'oxydation. Par exemple, le canal peut être dans un matériau inerte tel que des composants lithiés comme LiₓCoO₂, LiₓNiO₂, LiₓMn₂O₄, LiₓV₂O₅, LiₓWO₃, LiₓMO₃, LiₓTi₅O₁₂, où x est la fraction de lithium dans le composant.

De manière non limitative, le canal 14 peut comprendre du LiCoO₂, la couche 15 de matériau conducteur ionique et diélectrique peut comprendre de l'oxynitrure de phosphore de lithium (LiPON), qui est un matériau qui peut conduire les ions Li+ du canal 14.

Il est noté que d'autres couches peuvent être ajoutées au transistor ionique 1, par exemple une couche intercalaire en un matériau d'insertion d'ions située entre la couche de canal 14 et la couche 15 de matériau conducteur ionique et diélectrique. En outre, il est noté que la structure du transistor ionique peut différer de l'exemple représenté sur la Figure 1a. Par exemple, selon certaines réalisations, la couche de canal 14 peut recouvrir intégralement le drain 12 et la source 13, comme dans la demande US 10,429,343 par exemple.

Le niveau d'oxydation du canal 14 peut être modifié en appliquant une tension V_{G} appliquée entre la grille 16 et la source 13. Lorsqu'une tension V_{G} est appliquée entre la grille 16 et la source 13, cela induit une migration des ions entre la grille 16 et le canal 14, ce qui a pour effet de modifier la conductance électrique du canal 14 entre la source 13 et le drain 12, et donc l'état logique du transistor, un état logique étant associé à une valeur de conductance électrique respective du transistor. Les différentes valeurs de conductance (normalisées) du transistor ionique en fonction de la tension appliquée entre la grille 16 et la source 13 sont représentées sur la Figure 1b. Par conductance du transistor ionique, il est entendu la conductance électrique du canal 14.

Pour obtenir la courbe de la Figure 1b, des impulsions de tension successives ont été appliquées entre la grille 16 et la source 13. Sur l'exemple de la Figure 1b, chaque impulsion de tension a une amplitude de ±100 mV et une largeur de 0.1 seconde. Ces valeurs sont fournies à titre d'exemple et de manière non limitative. La courbe de la Figure 1b représente la variation de la conductance du transistor (en ordonnées) en fonction du numéro n d'impulsion de tension (en abscisses). Pour obtenir la courbe de la Figure 1b, 50 impulsions successives d'amplitude négative ont été appliquées (partie croissante de la courbe, appelée phase de potentialisation), puis 50 impulsions successives d'amplitude positive ont été appliquées (partie décroissante de la courbe, appelée phase de dépression).

Il apparaît de la Figure 1b que la conductance du canal 14 peut être modifiée de manière réversible selon la tension V_{G} appliquée entre la grille 16 et la source 13. En outre, la variation de la valeur de la conductance est linéaire pendant l'application d'une valeur constante non nulle de la tension. Elle croît de manière linéaire lorsqu'un créneau de tension d'amplitude négative est appliquée, et elle décroît de manière linéaire lorsqu'un créneau de tension d'amplitude positive est appliquée. En outre, l'application d'un créneau de tension d'amplitude positive « annule » les effets de l'application d'un créneau de tension de même durée et d'amplitude opposée (et réciproquement), en ce sens où elle ramène la valeur de la conductance à la valeur initiale.

Il est ainsi possible de modifier la conductance du transistor ionique 1 de la Figure 1a en jouant sur la valeur de la tension V_{G} appliquée entre la grille 16 et la source 13. Une fois que le transistor ionique a une certaine valeur de conductance, une tension V_{SD} est appliquée entre la source 13 et le drain 12 et un courant circule, la valeur de l'intensité du courant étant fixée par la valeur de conductance du transistor.

Les différentes valeurs de conductance associées aux différents numéros d'impulsion de courant correspondent à des états logiques (ou « états de conductance »). Chaque état logique est non volatil, et la transition d'un état logique à l'état suivant nécessite une très faible énergie (par exemple, une quantité d'énergie par surface active de l'ordre du fJ/µm²). En outre, comme cela apparaît sur la Figure 1b, un grand nombre (plusieurs dizaines) d'états logiques peuvent être atteints en potentialisation et en dépression de manière contrôlée (par le biais de la tension appliquée V_{G}), avec, comme mentionné ci-dessus, une linéarité de réponse qui est fonction de la plage de conductance considérée.

Il est noté que la vitesse de transition entre deux états logiques successifs du transistor ionique dépend en partie de l'épaisseur de la couche de canal 14 (l'épaisseur correspondant à la dimension selon l'axe y sur la Figure 1a) : plus la couche de canal 14 est fine, plus la vitesse de transition entre deux états logiques successifs est élevée. L'épaisseur de la couche de canal 14 peut être ainsi fixée, par exemple, entre 1 et 500 nm.

La vitesse de transition entre deux états logiques successifs dépend aussi en partie de l'épaisseur de la couche 15 de matériau conducteur ionique et diélectrique : plus la couche 15 de matériau conducteur ionique et diélectrique est fine, plus la vitesse de transition entre deux états logiques successifs est élevée. L'épaisseur de la couche 15 de matériau conducteur ionique et diélectrique peut être ainsi fixée, par exemple, entre 1 et 200 nm.

Comme détaillé ci-dessus, le transistor ionique est un transistor analogique permettant plusieurs dizaines d'états (ce qui est aujourd'hui difficile à obtenir à partir de transistors diélectriques et avec des mémoires résistives), ce qui en fait un composant de choix pour reproduire le fonctionnement des synapses, qui, dans le cerveau humain, permettent de connecter les neurones entre eux. Dans le cerveau humain, les neurones se mettent en action lorsque les synapses ont totalisé un certain nombre d'impulsions électriques, ce qui est rendu possible par un transistor à plusieurs dizaines d'états.

En outre, le transistor ionique exploite la même réaction électrochimique qu'une synapse, ce qui lui confère une excellente efficacité énergétique, du même ordre de grandeur qu'une synapse de cerveau humain.

Ces propriétés font du transistor ionique un composant particulièrement adapté pour les applications neuromorphiques.

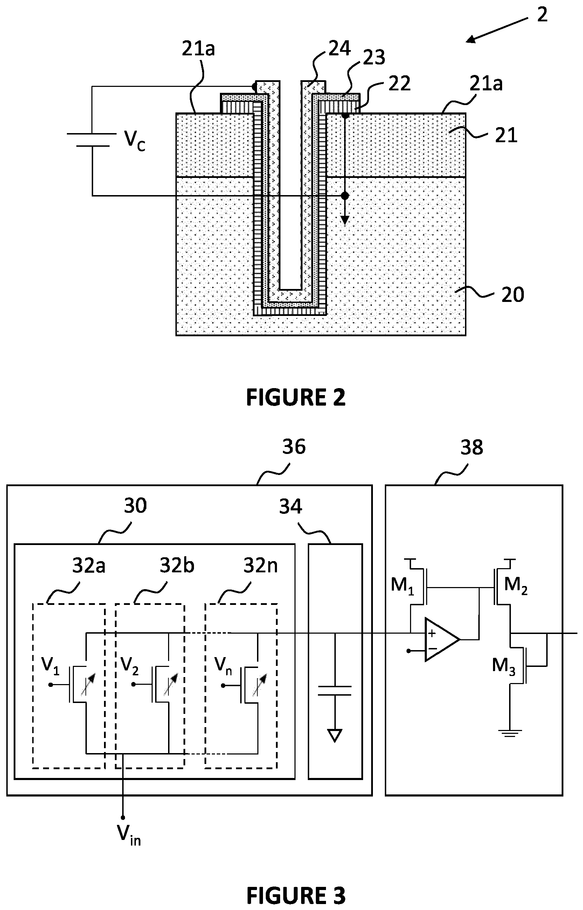

La Figure 2 représente une capacité ionique 2 (aussi appelée supercondensateur) selon l'état de la technique.

Une capacité ionique est un composant électrochimique de stockage, de type supercondensateur, composé de matériaux exclusivement sous forme solide. Une capacité ionique peut être chargée et déchargée en la connectant à un circuit électrique. Le stockage de charges se fait grâce aux modifications des matériaux qui composent la capacité ionique au cours des charges et des décharges. En effet, lorsqu'une tension est appliquée aux bornes de la capacité ionique, des déplétions / concentrations d'ions se produisent au niveau des deux interfaces conducteur ionique / électrode.

Comme représenté sur la Figure 2, une capacité ionique 2 comprend typiquement un substrat 20 recouvert d'une première couche 21 de diélectrique. Le substrat 20 est un substrat brut (c'est-à-dire non traité), ou il peut avoir déjà subi un traitement de sorte que d'autres composants électroniques ou couches sont déjà présents sur celui-ci. Sur l'exemple de la Figure 2, le substrat 20 et la couche 21 de diélectrique de la Figure 2 sont traversés par une cavité recouverte d'une couche 22 de matériau électriquement conducteur. La cavité est ici un trou borgne dont le fond est situé au niveau de substrat 20, à proximité de la surface inférieure du substrat 20. Cette couche 22 de matériau électriquement conducteur recouvre au moins partiellement la surface « libre » 21a de la première couche 21 de diélectrique (i.e. la surface 21a qui n'est pas contre le substrat 20 et qui n'est pas le long de la cavité formée) de part et d'autre de la cavité. La couche 22 de matériau électriquement conducteur forme l'une des électrodes de la capacité ionique 2, appelée ici électrode inférieure (en anglais, « bottom electrode »). La couche 22 de matériau électriquement conducteur est recouverte (au moins partiellement) d'une couche 23 d'un matériau à la fois conducteur ionique et diélectrique (diélectrique ionique). Cette couche 23 de conducteur ionique est recouverte (au moins partiellement) d'une couche 24 de matériau électriquement conducteur, qui forme l'autre électrode de la capacité ionique 2, appelée électrode supérieure (en anglais, « top electrode »). L'électrode inférieure 22 et l'électrode supérieure 24 sont donc isolées électriquement l'une de l'autre par la couche 23, qui permet toutefois aux ions de circuler entre les deux électrodes 22 et 24. Il apparaît alors une tension de charge Vc entre l'entrée et la sortie de la capacité ionique 2.

Il est noté que l'exemple représenté à la Figure 2 n'est pas limitatif et que d'autres configurations sont possibles. Par exemple, dans certaines configurations, la cavité ne traverse que la première couche 21 de diélectrique. En outre, la forme de la cavité n'est pas limitative, et peut être remplacée par un pore dans une couche 21 de diélectrique poreuse, tel que décrit dans la demande EP3570307.

Dans l'exemple de la Figure 2, l'électrode inférieure 22, la couche de diélectrique ionique 23 et l'électrode supérieure 24 de la capacité ionique 2 sont disposées selon une structure MIM (métal - isolant - métal) dans lequel l'isolant est un diélectrique conducteur d'ions (diélectrique ionique), mais d'autres configurations sont possibles, par exemple une configuration MOIM (métal - oxyde - diélectrique ionique - métal) dans laquelle une couche d'oxyde est intercalée entre l'électrode inférieure et la couche de diélectrique ionique, comme dans la demande EP3570307.

La présence de la cavité dans l'ensemble formé du substrat 20 et de la couche 21 de diélectrique de la Figure 2 n'est pas obligatoire, mais elle permet avantageusement d'augmenter la surface effective d'accumulation des charges entre les deux électrodes 22 et 24. En outre, il est noté que la capacité ionique 2 peut être formée selon une configuration planaire ou tridimensionnelle, une configuration tridimensionnelle permettant avantageusement d'augmenter la surface effective d'accumulation des charges entre les deux électrodes par unité de surface géométrique sur substrat, et donc d'augmenter la densité de capacité de la capacité ionique 2 (en jouant uniquement sur la géométrie de la capacité ionique).

L'application d'une tension entre l'électrode inférieure 22 et l'électrode supérieure 24 induit deux phénomènes physiques distincts : d'une part, l'établissement d'une double couche électrochimique entre le conducteur ionique 23 et les deux électrodes 22 et 24 (apparition d'une capacitance ionique), et d'autre part, la polarisation diélectrique du conducteur ionique 23 (apparition d'une capacitance diélectrique). La combinaison de ces deux phénomènes confère à la capacité ionique une densité de puissance par unité de surface très élevée, de l'ordre de quelques dizaines de µF/mm², c'est-à-dire de plusieurs ordres de grandeur supérieure aux densités de puissance des composants diélectriques de type MOS ou MIM.

La Figure 3 représente un exemple d'un système neuromorphique comprenant un élément électrochimique de stockage selon un mode de réalisation de l'invention.

L'élément électrochimique de stockage 36 de la Figure 3 comprend un élément résistif 30 et un élément capacitif 34 raccordés en série. L'élément résistif 30 comprend un seul transistor ionique ou plusieurs transistors ioniques 32a, 32b, ..., 32n raccordés en parallèle (dans le sens où chaque transistor a une source et un drain communs), comme représenté sur la Figure 3. Chaque transistor ionique 32a, 32b, ..., 32n modélise une synapse et est associé à une valeur respective de conductance qui correspond à un poids synaptique respectif, qui peut être stocké dans la capacité 34 (avec les autres poids synaptiques des autres transistors). Une tension V₁, V₂, ..., Vₙ est appliquée entre la grille et la source de chacun des transistors ioniques 32a, 32b, ... , 32n de sorte à faire varier leurs valeurs de conductance. Lorsqu'une tension Vᵢₙ est appliquée entre la source et le drain, cela génère un courant dont l'intensité est fonction de la conductance totale de l'élément résistif 30.

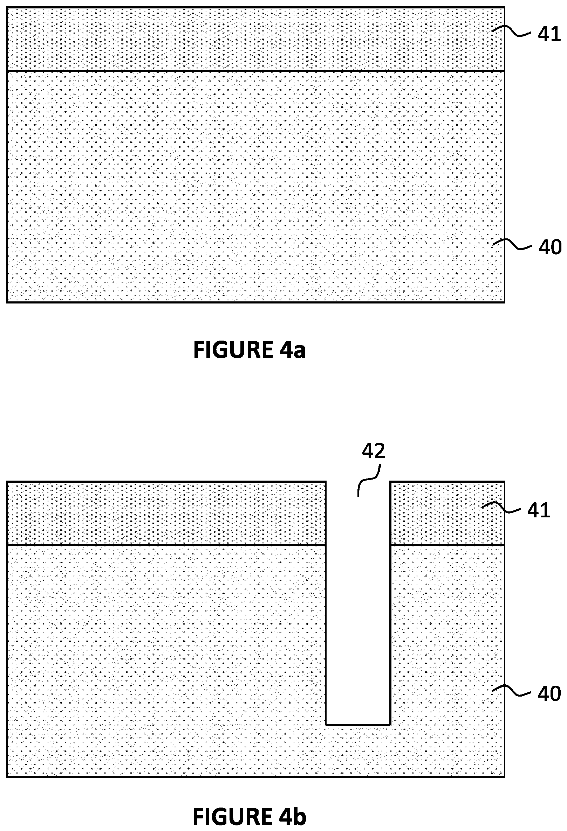

Le raccordement, en série, d'un élément résistif 30 à partir de transistors ioniques 32a, 32b, ..., 32n et d'un élément capacitif 34 à partir d'au moins une capacité ionique présente les avantages suivants. D'une part, l'élément résistif peut être dans une pluralité d'états analogiques (qui correspondent à différentes valeurs de conductance) non volatils, la transition d'un état à l'autre nécessitant une faible quantité d'énergie, ce qui fait de l'élément résistif 30 un composant particulièrement adapté aux applications neuromorphiques. Toutefois, du fait de la large gamme de valeurs de conductance de l'élément résistif 30, il est nécessaire de disposer d'une capacité qui peut accepter des valeurs importantes de quantités de charges (en coulomb) à ses bornes sans saturer ou se détériorer. A ce titre, l'élément capacitif ionique 34, qui présente une densité de capacité élevée, est un composant de stockage particulièrement adapté pour recevoir le courant de sortie de l'élément résistif 30. En outre, comme détaillé ci-après en référence aux Figures 4a à 4f, l'élément résistif 30 et l'élément capacitif 34 peuvent être réalisés à partir des mêmes matériaux, ce qui permet de les fabriquer sur un même substrat avec des étapes mutualisées, à partir de mêmes couches de matériaux, potentiellement sans mêmes à ajuster les épaisseurs.

Lorsqu'une tension d'entrée Vᵢₙ est appliquée entre la source et le drain du ou des transistors ioniques 32a, 32b, ..., 32n de l'élément résistif 30, l'élément résistif 30 entre dans un certain état analogique qui correspond à une certaine valeur de conductance, qui induit un courant en entrée de l'élément capacitif 34. L'élément capacitif 34 se charge alors, et la tension aux bornes de l'élément capacitif 34 dépend du courant d'entrée (donc du courant délivré par l'élément résistif 30).

Comme mentionné ci-dessus, l'élément capacitif 34 doit pouvoir supporter une large plage de quantités de charges sans saturer ou se dégrader, du fait de la large gamme de valeurs de conductance de l'élément résistif 30. Par exemple, un élément capacitif diélectrique ne serait pas en mesure d'assurer une telle fonction (ou alors il serait nécessaire d'utiliser un grand nombre de capacités diélectriques, ce qui n'est pas souhaitable pour des raisons de coûts et d'encombrement). C'est pourquoi un élément capacitif ionique est particulièrement adapté.

Sur l'exemple de la Figure 3, un circuit comparateur 38 est raccordé en série à la sortie de l'élément électrochimique de stockage 36. Par exemple, le circuit comparateur 38 comprend un amplificateur opérationnel configuré pour déclencher une opération lorsque la tension aux bornes de l'élément capacitif 34 atteint un seuil prédéterminé. Sur l'exemple de la Figure 3, le circuit comparateur 38 est un capteur analogique de type CMOS impliquant trois transistors M₁, M₂, M₃, mais cela n'est pas limitatif, n'importe quel circuit comparateur peut être utilisé.

Un montage tel que celui représenté dans la Figure 3 peut être utilisé pour des applications neuromorphiques. Chaque transistor ionique 32a, 32b, ..., 32n correspond à une synapse respective. Les transistors ioniques 32a, 32b, ..., 32n sont en effet particulièrement adaptés pour jouer le rôle de synapses artificielles, puisqu'ils ont des conductances variables en fonction de la tension qui leur est appliquée en entrée, et que leurs états sont non volatils, ce qui permet de reproduire la caractéristique synaptique appelée « plasticité fonction du temps d'occurrence des impulsions » (en anglais, « Spike timing dependent plasticity », ou STDP), selon laquelle plus la synapse est stimulée, plus l'apprentissage s'améliore. L'élément capacitif 34 simule le potentiel d'action d'un neurone biologique, qui assure la séparation des charges électriques à travers la membrane cellulaire. Le montage de la Figure 3 permet ainsi de reproduire le fonctionnement d'un neurone, en déclenchant une action (via le circuit comparateur 38) lorsqu'un certain seuil d'activation du neurone artificiel est atteint (ici, lorsque la capacité de l'élément capacitif 34 atteint une certaine valeur), de manière similaire au potentiel d'action du neurone du cerveau humain.

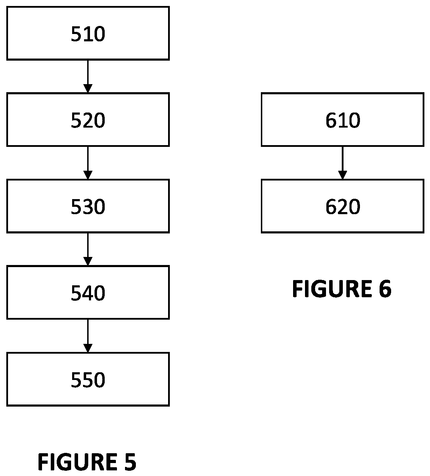

En d'autres termes, le fonctionnement de l'élément électrochimique de stockage 36 peut donc comprendre les étapes suivantes, représentées à la Figure 6 :
- étape d'écriture : un signal électrique (tension V₁, ..., Vₙ ou courant) est appliqué (étape 610) entre la source et la grille de chaque transistor ionique 32a, ..., 32n pour que celui-ci entre dans un état de conductance donné ;
- étape de lecture : un signal électrique (tension Vᵢₙ ou courant) est appliqué (étape 620) entre la source et le drain de chaque transistor ionique 32a, ..., 32n, ce qui génère un courant, appelé « courant de lecture », qui est transmis à l'élément capacitif 34, permettant un stockage de charges proportionnel au courant de lecture.

Il est noté que l'élément électrochimique de stockage 36 peut être vu comme un circuit RC monté en série. La constante de temps associée est donc approximativement égale à R×C, où R désigne la valeur de la résistance de l'élément résistif 30 (et donc, pour un seul transistor 32a, l'inverse de la valeur de conductance du transistor) et C la valeur de la capacité de l'élément capacitif 34. Il est ainsi possible, à partir du temps de charge de l'élément capacitif 34, de déterminer la valeur de la résistance (ou de la conductance) de l'élément résistif 30, et donc le poids synaptique. Le temps de charge peut être déterminé par exemple en mesurant le temps entre la génération d'un courant d'entrée de l'élément capacitif 34 et le déclenchement de l'événement par le circuit comparateur 36.

Comme mentionné précédemment, l'élément électrochimique de stockage 36 présente l'avantage de pouvoir être réalisé sur un même substrat, par dépôt de couches successives, comme décrit maintenant en référence aux Figures 4a à 4f.

Les Figures 4a à 4f illustrent des étapes d'un procédé de fabrication d'un élément électrochimique de stockage selon un mode de réalisation de l'invention. L'ordinogramme de ce procédé de fabrication est représenté à la Figure 5.

Lors d'une première étape 510 (Figure 5) du procédé, une couche isolante électrique peut être déposée sur un substrat. Cette étape est illustrée sur la Figure 4a.

Comme représenté sur la Figure 4a, une couche 41 isolante électrique (par exemple en un matériau diélectrique) est formée sur un substrat 40, par exemple par un procédé de dépôt pleine plaque. Le substrat 40 peut être une plaque de matériau semiconducteur. Dans certains modes de réalisation, cette plaque intègre un ou plusieurs composants tels que des transistors classiques ou des microsystèmes. En particulier, l'intégration du dispositif de stockage de la présente invention peut être réalisée en « Back End Of Line », c'est-à-dire après la réalisation du niveau CMOS et dans des niveaux supérieurs, au même titre que les contacts. Il est noté que la couche conductrice ionique 41 peut constituer à elle seule le substrat (dans certains modes de réalisation donc, il peut n'y avoir qu'une couche diélectrique 41 qui remplace les deux couches 40 et 41 des Figures 4a à 4f).

La couche diélectrique 41 peut être composée d'un ou plusieurs matériaux permettant une isolation électrique, par exemple un oxyde, un nitrure, un oxynitrure, ou tout matériau ou combinaison de matériau pouvant faire office de passivation chimique et électrique entre le substrat 40 et l'élément mémoire.

Dans un mode de réalisation non limitatif, le substrat 40 peut être une plaque de silicium et la couche 41 peut être une couche d'oxyde de silicium.

En outre, lors de la première étape 510 du procédé représenté à la Figure 5, l'ensemble composé du substrat et de la couche conductrice ionique peut être structuré pour former un évidement destiné à recevoir la capacité ionique. Cette structuration est représentée sur la Figure 4b.

Comme représenté à la Figure 4b, l'ensemble « substrat 40 / couche diélectrique 41 » peut être structuré pour créer une ouverture 42 (ou « cavité » ou « sillon ») perpendiculairement au plan de surface de la couche diélectrique 41 et du substrat 40. Cette structuration est réalisée à travers la couche diélectrique 41 et le substrat 40, et s'arrête dans le volume de substrat sans le traverser. Sur l'exemple de la Figure 4b, l'ouverture 42 est un trou borgne dans la couche diélectrique 41 qui traverse une partie du substrat 40, et dont le fond est situé à proximité de la surface inférieure du substrat 40. Il est noté que selon les modes de réalisation, l'ouverture 42 peut traverser le substrat selon une profondeur variable, voire ne traverser que tout ou partie de la couche diélectrique 41 (et donc ne pas traverser le substrat 40). Dans certains modes de réalisation, la structuration peut être effectuée par une technique de photolithographie (comprenant typiquement un dépôt d'une couche de résine par enduction centrifuge - ou « spin coating » en anglais sur l'ensemble « substrat 40 / couche diélectrique 41 », une insolation à travers un masque et un développement de la résine insolée) suivie d'une gravure plasma.

Comme mentionné en référence à la Figure 2, la présence de l'ouverture 42 n'est pas obligatoire, mais elle permet avantageusement d'augmenter la surface effective d'accumulation des charges entre les deux électrodes 43b et 47b.

En référence à nouveau à la Figure 5, lors d'une étape 520, une première couche d'un matériau électriquement conducteur peut être déposée sur la surface du substrat, et structurée en deux parties n'ayant aucun point de contact, l'une faisant office d'électrode de source au transistor ionique, et l'autre comprenant à la fois d'électrode de drain et l'électrode inférieure de la capacité ionique.

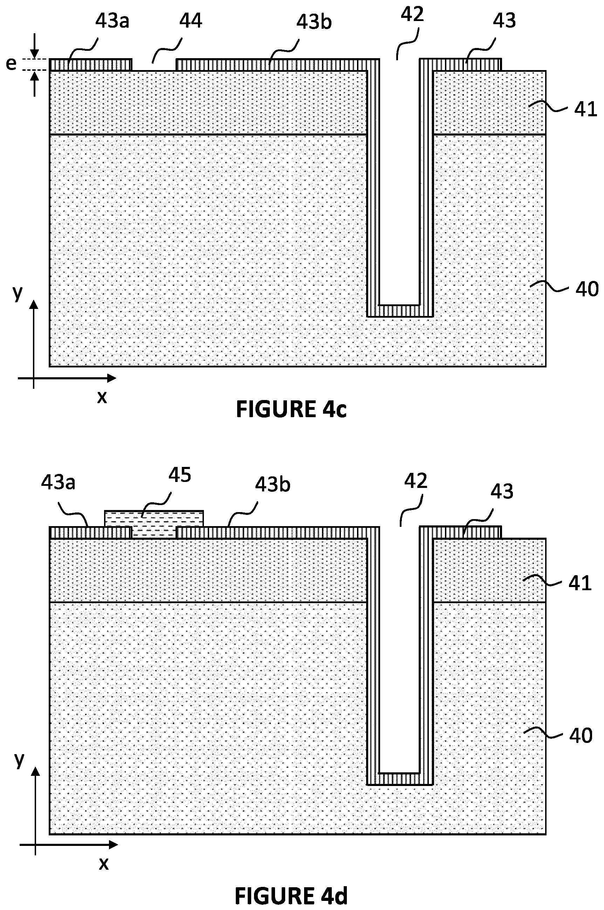

Cette étape 520 est représentée sur la Figure 4c : une couche 43 de matériau électriquement conducteur est formée sur une partie de la surface de la couche diélectrique 41 et au niveau de l'ouverture 42 le cas échéant. La couche 43 de matériau électriquement conducteur comprend deux parties 43a, 43b séparées d'un espace 44, de sorte que les deux parties 43a, 43b de la couche de matériau électriquement conducteur 43 n'ont aucun point de contact l'une avec l'autre et ne sont pas connectées électriquement. Sur l'exemple de la Figure 4c, la partie 43b de la couche 43 de matériau électriquement conducteur recouvre une partie de la surface non structurée de l'ensemble « substrat 40 / couche diélectrique 41 » (i.e. la partie de la surface de l'ensemble « substrat 40 / couche diélectrique 41 » qui n'est pas au niveau de l'ouverture 42) ainsi que les parois et le fond de l'ouverture 42. Comme décrit ci-après, la partie 43a joue le rôle de « source » du transistor ionique du composant de stockage, et la partie 43b joue à la fois le rôle de « drain » du transistor ionique du composant de stockage et d'électrode inférieure de la capacité ionique du composant de stockage. Il est noté que les électrodes de source et de drain peuvent être interchangées (en particulier, l'électrode 43a peut représenter le drain et l'électrode 43b peut représenter la source).

La couche 43 de matériau électriquement conducteur peut être typiquement réalisée par dépôt sur toute la surface de l'ensemble « substrat 40 / couche diélectrique 41 » structuré de la Figure 4b (y compris les parois et le fond de l'ouverture 42), puis par structuration afin de réaliser l'espace 44 et de donner la forme et les dimensions souhaitées aux différentes parties de la couche 43. Par exemple, la couche 43 peut être déposée par pulvérisation cathodique sous vide, et la structuration peut être assurée par photolithographie suivie d'une gravure sèche.

Dans certains modes de réalisation, le dépôt de la couche 43 de matériau électriquement conducteur peut avantageusement être un dépôt conforme sur la surface de l'ensemble « substrat 40 / couche diélectrique 41 » structuré, c'est-à-dire que son épaisseur constante sur toute la surface. Cela simplifie le procédé de fabrication de l'élément électrochimique de stockage, puisqu'une seule couche peut être déposée le long de la surface sans nécessité de faire varier l'épaisseur en ajoutant des couches additionnelles.

Dans certains modes de réalisation, la couche 43 peut être une couche métallique de titane ayant une épaisseur e (qui correspond à la dimension selon l'axe y sur la Figure 4c, i.e. selon la direction orthogonale à la surface du substrat 40) comprise entre 10 et 200 nm, par exemple égale à 100 nm.

En référence à nouveau à la Figure 5, lors d'une étape 530, une couche d'un matériau d'insertion d'ions appelée couche de canal est déposée au niveau de l'espace entre l'électrode de source et l'électrode de drain du transistor ionique, de sorte à être en contact à la fois avec l'électrode de source et l'électrode de drain du transistor ionique.

Cette étape 530 est illustrée sur la Figure 4d : une couche 45 d'un matériau d'insertion d'ions est formée et structurée de sorte à recouvrir la partie de la couche 41 localisée au niveau de l'espace 34, ainsi que des portions des parties 43a et 43b de la couche 43, lesdites portions incluant les extrémités des parties 43a et 43b situées au niveau de l'espace 44. Comme décrit ci-après, cette couche 45 constitue le canal du transistor ionique du composant de stockage, et est donc en contact avec la source 43a, le drain 43b et la partie de la couche 41 localisée au niveau de l'espace 44.

Le canal 45 est composé d'un matériau d'insertion d'ions permettant d'intercaler et de dé-intercaler des ions sous l'application d'un champ électrique et, ainsi, de changer la conductivité électrique du canal 45 en fonction du taux d'intercalation. Par exemple, le matériau composant le canal 45 peut être un oxyde de métal de transition, et plus particulièrement un métal à base de nanoparticules de dioxyde de titane (TiO₂) ayant une taille d'environ 10 nm, pouvant intercaler les ions lithium (Li+). Le canal 45 peut, par exemple, avoir une épaisseur de l'ordre de quelques nanomètres à quelques dizaines de nanomètres.

De référence à nouveau à la Figure 5, lors d'une étape 540, une couche d'un matériau à la fois conducteur ionique et diélectrique peut être déposée sur la surface de l'élément obtenu à l'issue de l'étape 530, puis structurée en deux parties n'ayant aucun point de contact. La première partie recouvre la couche de canal et est en contact avec l'électrode de source et l'électrode de drain. La deuxième partie recouvre partiellement l'électrode inférieure de la capacité ionique.

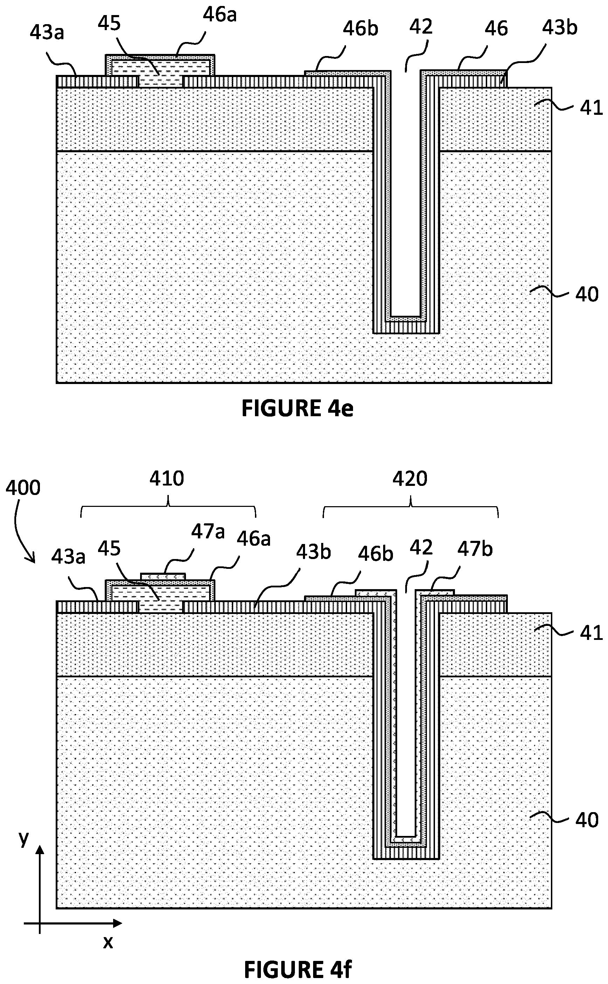

Cette étape 540 est illustrée sur la Figure 4e : une couche 46 de conducteur ionique et diélectrique est déposée et structurée. La couche 46 est conductrice pour les mêmes ions que le matériau d'insertions d'ions composant le canal 45. Par exemple, si le canal 45 est dans un matériau permettant l'intercalation d'ions Li+, le matériau de la couche 46 est conducteur pour les ions Li+.

La couche 46 de conducteur ionique et diélectrique comprend deux parties 46a, 46b qui n'ont aucun point de contact. L'une des parties 46a recouvre le canal 45 de sorte à être en contact avec la source 43a et le drain 43b du transistor ionique de l'élément électrochimique de stockage. L'autre partie 46b recouvre une portion de la partie 43b de la couche 43 de matériau électriquement conducteur, ladite portion de la partie 43b de la couche 43 de matériau électriquement conducteur incluant la portion de la partie 43b de la couche 43 de matériau électriquement conducteur au niveau de l'ouverture 42.

La couche 46 est composée d'un matériau conducteur ionique et diélectrique, qui permet aux ions de circuler d'une part entre la source 43a et le drain 43b via le canal du transistor ionique de l'élément de stockage, et d'autre part entre les deux électrodes 43b et 47b de la capacité ionique de l'élément de stockage, tout en assurant une isolation électrique entre eux. Par exemple, ce matériau peut être un oxynitrure de phosphore de lithium (LiPON). La couche 46 peut avoir une épaisseur de quelques dizaines à quelques centaines de nm, par exemple 100 nm. Dans certains modes de réalisation, cette couche 46 est déposée par pulvérisation cathodique magnétron. La structuration peut être effectuée par photolithographie par exemple.

Dans certains modes de réalisation, le dépôt de la couche 46 de matériau conducteur ionique et diélectrique peut avantageusement être un dépôt conforme sur la surface de l'élément de la Figure 4d.

Enfin, lors d'une étape 550 de la Figure 5, une couche d'un matériau électriquement conducteur peut être déposée sur la surface de l'élément obtenu à l'issue de l'étape 540, puis structurée en deux parties n'ayant aucun point de contact. La première partie recouvre partiellement la première partie de la couche déposée à l'étape 540 et n'est en contact ni avec l'électrode de source, ni avec l'électrode de drain. Cette première partie forme l'électrode de grille du transistor ionique. La deuxième partie recouvre au moins partiellement la deuxième partie de la couche déposée à l'étape 540, et n'est pas en contact avec l'électrode inférieure de la capacité ionique. Cette deuxième partie forme l'électrode supérieure de la capacité ionique.

Cette étape 550 est illustrée sur la Figure 4f, dans laquelle une couche d'un matériau électriquement conducteur est déposée sur au moins une partie de la couche 46. Cette couche comprend deux parties 47a, 47b qui n'ont aucun point de contact. La première partie 47a recouvre une partie de la surface de la partie 46a de la couche 46 et forme la grille du transistor ionique de l'élément de stockage. La deuxième partie 47b recouvre au moins partiellement la partie 46b de la couche 46 et forme l'électrode supérieure de la capacité ionique de l'élément de stockage. Dans certains modes de réalisation, le dépôt de la couche 47 de matériau électriquement conducteur peut avantageusement être un dépôt conforme sur la surface de l'élément de la Figure 4e.

Par exemple, la couche 47a, 47b peut être une couche métallique de titane ayant une épaisseur de 100 nm, déposée par pulvérisation cathodique sous vide. La structuration de la couche 47a, 47b peut être par exemple réalisée par photolithographie et gravure sèche.

Les exemples de mode de réalisation ci-dessus se concentrent sur un composant mémoire à fonctionnement d'ions lithium Li+, mais il est tout à fait possible d'utiliser d'autres ions porteurs de charge, tels que des ions Na+, H+, K+, Cu+, etc.

L'élément électrochimique de stockage 400 de la Figure 4f est représenté en coupe sur le plan (x, y). Dans un ou plusieurs modes de réalisation, la largeur de canal peut être inférieure à 200 nm, préférentiellement inférieure à 20 nm. La largeur de canal correspond à la dimension selon l'axe z (z étant le troisième axe d'un repère orthonormal (x, y, z)) du canal 45 du transistor ionique 420. La largeur de la capacité ionique 420 (i.e. la dimension de la capacité ionique 420 selon l'axe z) peut être inférieure à 2 µm, préférentiellement inférieure à 1 µm. La profondeur de capacité ionique 420 (i.e. sa dimension selon l'axe y) peut être supérieure à 2 µm, préférentiellement supérieure à 5 µm.

L'élément électrochimique de stockage 400 obtenu à l'issue des différentes étapes représentées aux Figures 4a à 4f comprend un transistor ionique 410 (de structure similaire au transistor ionique 1 représenté à la Figure 1a) et une capacité ionique 410 (de structure similaire à la capacité ionique 2 représentée à la Figure 2) connectés en série. En supposant que le transistor ionique 410 est dans un état de conductance donné, lorsqu'une tension est appliquée entre la source 43a et le drain 43b du transistor ionique 410, cela génère un courant qui est transmis à la capacité ionique 420 par le biais de la couche 43b qui joue à la fois le rôle de drain du transistor ionique 410 et d'électrode inférieure de la capacité ionique 420, engendrant ainsi un stockage de charges au niveau de la capacité ionique 420.

Le transistor ionique 410 et la capacité ionique 420 sont réalisés de façon monolithique sur le même niveau du substrat 40. Comme il apparaît ci-dessus, un tel élément peut être fabriqué en mutualisant certaines étapes de fabrication du transistor et de la capacité ionique (dépôt d'une même couche pour les deux composants et structuration).

L'élément 400 de la Figure 4f est un exemple d'un élément électrochimique de stockage 36 tel que présenté en référence à la Figure 3, dans lequel l'élément résistif 30 comprend un unique transistor ionique 32a (le composant 410) et dans lequel l'élément capacitif 34 comprend une unique capacité ionique 420. Bien entendu, l'élément de stockage 400 de la Figure 4f peut être modifié pour comprendre plusieurs transistors ioniques 410 en parallèle. Par exemple, dans une structure 3D, une pluralité de transistors ioniques tels que le transistor ionique 410 peuvent être réalisés en parallèle et connectés en série à une capacité ionique 420.

Bien entendu, la présente invention ne se limite pas aux formes de réalisation décrites ci-avant à titre d'exemples. Elle s'étend à d'autres variantes. Par exemple, d'autres composants peuvent être intercalés entre le transistor ionique et la capacité ionique. Le transistor ionique et/ou la capacité ionique peuvent également comprendre des couches additionnelles. Par exemple, une couche intercalaire dans un matériau d'insertion d'ions dissociée de celle du transistor ionique peut être implémentée dans l'architecture de la capacité ionique, de sorte à avoir une capacité hybride. Par exemple, cette couche intercalaire peut être insérée au niveau de la capacité ionique, entre la couche 43b et la couche 46b de la Figure 4f, i.e. entre l'électrode inférieure et la couche conductrice ionique de la capacité ionique. Une telle implémentation permet d'augmenter davantage la valeur de la densité de capacitance (en pratique, celle-ci peut être doublée en comparaison avec une isoarchitecture sans couche intercalaire), comme décrit par exemple dans l'article de V. Sallaz et al. « Hybrid All-Solid-State Thin-Film Micro-supercapacitor Based on a Pseudocapacitive Amorphous TiO2 Electrode », ACS Appl. Energy Mater. 2023, 6, 1, 201-210. Une telle couche intercalaire peut être obtenue à partir du procédé de fabrication de la Figure 5 : à l'étape 530, la couche de matériau d'insertion d'ions peut être déposée sur toute la surface, et structurée en deux parties disjointes : l'une correspondant à la couche de canal du transistor ionique, l'autre correspondant à la couche intercalaire de la capacité ionique.

## Revendications

1. Dispositif (400) électrochimique de stockage de charges comprenant un transistor ionique (410) et une capacité ionique (420),
le transistor ionique (410) comprenant :
- une couche (45) formant un réservoir d'ions, appelée couche réservoir ;
- une électrode de source (43a) en contact avec une partie de la couche réservoir (45) ;
- une électrode de drain (43b) en contact avec une autre partie de la couche réservoir (45), l'électrode de drain (43b) et l'électrode de source (43a) étant physiquement séparées l'une de l'autre, l'électrode de source (43a) et l'électrode de drain (43b) étant chacune dans un matériau électriquement conducteur ; et
- une électrode de grille (47a) dans un matériau électriquement conducteur, l'électrode de grille étant séparée de la couche réservoir par une couche conductrice ionique (46a) dans un matériau conducteur ionique et diélectrique, la couche conductrice ionique (46a) étant en contact avec l'électrode de source (43a) et avec l'électrode de drain (43b) ;
la capacité ionique (420) comprenant deux électrodes (43b, 47b), chacune des deux électrodes (43b, 47b) étant dans un matériau électriquement conducteur, la capacité ionique (420) comprenant une couche conductrice ionique (46b) séparant les deux électrodes (43b, 47b) de la capacité ionique (420), la couche conductrice ionique de la capacité ionique (420) étant dans un matériau conducteur ionique et diélectrique ;
dans lequel le transistor ionique (410) et la capacité ionique (420) sont connectés électriquement en série.

2. Dispositif (400) selon la revendication 1, dans lequel la couche conductrice ionique (46a) du transistor ionique (410) et la couche conductrice ionique (46b) de la capacité ionique (420) sont dans un même matériau conducteur ionique et diélectrique.

3. Dispositif (400) selon la revendication 2, dans lequel le matériau conducteur ionique et diélectrique est un oxynitrure de phosphore de lithium LiPON, un oxynitrure de lithium-silicium-phosphore LiSiPON, un sulfure de phosphore de germanium de lithium LGPS, un oxyde de lithium lanthane zirconium LiLaZrₓO_{y} ou un oxyde de lithium lanthane tantale LiLaTaOₓ.

4. Dispositif (400) selon l'une des revendications précédentes, dans lequel la couche réservoir (45) et la couche conductrice ionique (46a) du transistor ionique sont dans un même matériau conducteur ionique et diélectrique.

5. Dispositif (400) selon l'une des revendications précédentes, dans lequel la couche conductrice ionique (46a) du transistor ionique et la couche conductrice ionique (46b) de la capacité ionique ont une même épaisseur.

6. Dispositif (400) selon l'une des revendications précédentes, dans lequel le transistor ionique (410) et la capacité ionique (420) sont situés sur un même substrat (40, 41), de manière monolithique.

7. Dispositif (400) selon la revendication 6, dans lequel le transistor ionique (410) et la capacité ionique (420) sont situés sur un même niveau du substrat (40, 41).

8. Dispositif (400) selon la revendication 6 ou 7, dans lequel le substrat (40, 41) comprend un évidement (42), dans lequel au moins une partie de la capacité ionique (420) est logée dans l'évidement (42).

9. Dispositif (400) selon l'une des revendications précédentes, dans lequel l'électrode de source (43a) du transistor ionique, l'électrode de drain (43b) du transistor ionique et l'une des électrodes, appelée électrode inférieure (43b), de la capacité ionique sont dans un même matériau électriquement conducteur et ont une même épaisseur.

10. Dispositif (400) selon la revendication 9, dans lequel l'électrode inférieure (43b) de la capacité ionique et l'une des électrodes (43b) parmi l'électrode de drain et l'électrode de source du transistor ionique sont communes.

11. Circuit comprenant un dispositif (400) électrochimique de stockage de charges selon l'une des revendications 1 à 10, le circuit comprenant en outre un bloc comparateur (38) connecté en série à une sortie de la capacité ionique (34), le bloc comparateur (38) étant configuré pour déclencher un signal lorsqu'une tension aux bornes de la capacité ionique (34) atteint une valeur de tension de référence.

12. Circuit selon la revendication 11, dans lequel le bloc comparateur (38) comprend un amplificateur opérationnel recevant, sur une entrée, la tension aux bornes de la capacité ionique et, sur une autre entrée, la valeur de tension de référence, le signal étant déclenché lorsque la tension aux bornes de la capacité ionique atteint la valeur de tension de référence, le signal correspondant à une réponse d'une synapse artificielle.

13. Circuit selon la revendication 11 ou 12, comprenant en outre des moyens pour déterminer un temps mis par la capacité ionique (38) pour que la tension à ses bornes atteigne la tension de référence.

14. Procédé de fabrication d'un dispositif électrochimique de stockage de charges selon l'une des revendications 1 à 10, le procédé comprenant successivement :
- dépôt (520), sur un substrat, d'une première couche de matériau électriquement conducteur, et structuration de ladite première couche de sorte à obtenir une première partie de la première couche et une deuxième partie de la première couche n'ayant aucun point de contact, la première partie de la première couche correspondant à une électrode parmi une électrode de source et une électrode de grille du transistor ionique, la deuxième partie de la première couche correspondant à l'autre électrode parmi l'électrode de source et l'électrode de drain du transistor ionique et à une première électrode parmi les deux électrodes de la capacité ionique ;
- dépôt (530) de la couche réservoir, la couche réservoir étant en contact avec l'électrode de source et l'électrode de drain du transistor ionique ;
- dépôt (540) d'une couche conductrice ionique dans un matériau conducteur ionique et diélectrique, et structuration de la couche conductrice ionique de sorte à obtenir une première partie de la couche conductrice ionique et une deuxième partie de la couche conductrice ionique n'ayant aucun point de contact, la première partie recouvrant la couche réservoir et étant en contact avec l'électrode de source et l'électrode de drain du transistor ionique, la deuxième partie recouvrant au moins partiellement la première électrode de la capacité ionique ;
- dépôt (550) d'une deuxième couche de matériau électriquement conducteur, et structuration de ladite deuxième couche de sorte à obtenir une première partie de la deuxième couche et une deuxième partie de la deuxième couche n'ayant aucun point de contact, la première partie de la deuxième couche recouvrant partiellement la première partie de la couche conductrice ionique et n'ayant aucun point de contact avec la première partie de la première couche et la deuxième partie de la première couche, la deuxième partie de la deuxième couche recouvrant au moins partiellement la deuxième partie de la couche conductrice ionique et n'ayant aucun point de contact avec la deuxième partie de la première couche, la première partie de la deuxième couche correspondant à l'électrode de grille du transistor ionique, la deuxième partie de la deuxième couche correspondant à une deuxième électrode parmi les deux électrodes de la capacité ionique, la deuxième électrode étant distincte de la première électrode.

15. Procédé de fabrication selon la revendication précédente, dans lequel le dépôt d'au moins une couche parmi la première couche de matériau électriquement conducteur, la couche conductrice ionique et la deuxième couche de matériau électriquement conducteur est un dépôt conforme.

16. Procédé de stockage de charges utilisant un dispositif électrochimique de stockage selon l'une des revendications 1 à 10, comprenant :
- appliquer (610) une tension au niveau de l'électrode de grille du transistor ionique, de sorte à fixer une valeur de conductance prédéfinie pour le transistor ionique ;
- générer (620) un courant circulant entre le transistor ionique et la capacité ionique, une valeur d'intensité du courant de sortie du transistor ionique correspondant à une valeur d'entrée du courant d'entrée de la capacité ionique.

## Patentansprüche

1. Elektrochemische Ladungsspeichervorrichtung (400) mit einem Ionentransistor (410) und einem Ionenkondensator (420),
wobei der lonentransistor (410) umfasst:
- eine Schicht (45), die einen lonenbehälter bildet, die als Reservoirschicht bezeichnet wird;
- eine Source-Elektrode (43a), die mit einem Teil der Reservoirschicht (45) in Kontakt steht;
- eine Drain-Elektrode (43b), die mit einem anderen Teil der Reservoirschicht (45) in Kontakt steht, wobei die Drain-Elektrode (43b) und die Source-Elektrode (43a) physikalisch voneinander getrennt sind, und wobei die Source-Elektrode (43a) und die Drain-Elektrode (43b) jeweils aus einem elektrisch leitfähigen Material bestehen; und
- eine Gate-Elektrode (47a) aus einem elektrisch leitfähigen Material, wobei die Gate-Elektrode von der Reservoirschicht durch eine ionisch leitfähige Schicht (46a) aus einem ionisch leitfähigen und dielektrischen Material getrennt ist, wobei die ionisch leitfähige Schicht (46a) mit der Source-Elektrode (43a) und mit der Drain-Elektrode (43b) in Kontakt steht;
wobei der Ionenkondensator (420) zwei Elektroden (43b, 47b) umfasst, die beide (43b, 47b) aus einem elektrisch leitfähigen Material bestehen, wobei der Ionenkondensator (420) eine ionisch leitfähige Schicht (46b) umfasst, die die beiden Elektroden (43b, 47b) des Ionenkondensators (420) voneinander trennt, wobei die ionisch leitfähige Schicht des lonenkondensators (420) aus einem ionisch leitfähigen und dielektrischen Material besteht;
wobei der Ionentransistor (410) und der Ionenkondensator (420) elektrisch in Reihe geschaltet sind.

2. Vorrichtung (400) nach Anspruch 1, in der die ionisch leitfähige Schicht (46a) des Ionentransistors (410) und die ionisch leitfähige Schicht (46b) des Ionenkondensators (420) aus dem gleichen ionisch leitfähigen und dielektrischen Material bestehen.

3. Vorrichtung (400) nach Anspruch 2, in der das ionisch leitfähige und dielektrische Material ein Lithium-Phosphor-Oxynitrid LiPON, ein Lithium-Silizium-Phosphor-Oxynitrid LiSiPON, ein Lithium-Germanium-PhosphorSulfid LGPS, ein Lithium-Lanthan-Zirkonium-Oxid LiLaZrₓO_{y} oder ein Lithium-Lanthan-Tantal-Oxid LiLaTaOₓ ist.

4. Vorrichtung (400) nach einem der vorhergehenden Ansprüche, in der die Reservoirschicht (45) und die ionisch leitfähige Schicht (46a) des Ionentransistors aus dem gleichen ionisch leitfähigen und dielektrischen Material bestehen.

5. Vorrichtung (400) nach einem der vorhergehenden Ansprüche, in der die ionisch leitfähige Schicht (46a) des Ionentransistors und die ionisch leitfähige Schicht (46b) des Ionenkondensators die gleiche Dicke aufweisen.

6. Vorrichtung (400) nach einem der vorhergehenden Ansprüche, in der der Ionentransistor (410) und der Ionenkondensator (420) monolithisch auf demselben Substrat (40, 41) angeordnet sind.

7. Vorrichtung (400) nach Anspruch 6, in der der Ionentransistor (410) und der Ionenkondensator (420) auf derselben Ebene des Substrats (40, 41) angeordnet sind.

8. Vorrichtung (400) nach Anspruch 6 oder 7, in der das Substrat (40, 41) eine Aussparung (42) aufweist, in der mindestens ein Teil des lonenkondensators (420) in der Aussparung (42) untergebracht ist.

9. Vorrichtung (400) nach einem der vorhergehenden Ansprüche, in der die Source-Elektrode (43a) des Ionentransistors, die Drain-Elektrode (43b) des Ionentransistors und die als untere Elektrode (43b) der Elektroden des Ionenkondensators aus dem gleichen elektrisch leitfähigen Material bestehen und die gleiche Dicke aufweisen.

10. Vorrichtung (400) nach Anspruch 9, in der die untere Elektrode (43b) des Ionenkondensators und eine der Elektroden (43b) aus der Drain-Elektrode und der Source-Elektrode des Ionentransistors gemeinsam sind.

11. Schaltung mit einer elektrochemischen Ladungsspeichervorrichtung (400) nach einem der Ansprüche 1 bis 10, wobei die Schaltung ferner einen Vergleicherblock (38) umfasst, der mit einem Ausgang des Ionenkondensators (34) in Reihe geschaltet ist, wobei der Vergleicherblock (38) so konfiguriert ist, dass er ein Signal auslöst, wenn eine Spannung an den Anschlüssen des Ionenkondensators (34) einen Referenzspannungswert erreicht.

12. Schaltung nach Anspruch 11, in der der Vergleicherblock (38) einen Operationsverstärker umfasst, der an einem Eingang die Spannung an den Anschlüssen des Ionenkondensators und an einem anderen Eingang den Referenzspannungswert empfängt, wobei das Signal ausgelöst wird, wenn die Spannung an den Anschlüssen des Ionenkondensators den Referenzspannungswert erreicht, wobei das Signal einer Reaktion einer künstlichen Synapse entspricht.

13. Schaltung nach Anspruch 11 oder 12, die außerdem Mittel umfasst, um die Zeit zu bestimmen, die der Ionenkondensator (38) benötigt, damit die Spannung an seinen Anschlüssen die Referenzspannung erreicht.

14. Verfahren zur Herstellung einer elektrochemischen Ladungsspeichervorrichtung nach einem der Ansprüche 1 bis 10, wobei das Verfahren nacheinander umfasst:
- Aufbringen (520) einer ersten Schicht aus elektrisch leitfähigem Material auf ein Substrat und Strukturieren der ersten Schicht, um einen ersten Teil der ersten Schicht und einen zweiten Teil der ersten Schicht zu erhalten, die keinen Kontaktpunkt haben, wobei der erste Teil der ersten Schicht einer Elektrode entspricht, die entweder eine Source-Elektrode oder eine Gate-Elektrode des Ionentransistors ist, und der zweite Teil der ersten Schicht der anderen Elektrode entspricht, die entweder die Source-Elektrode oder die Drain-Elektrode des Ionentransistors ist, sowie einer ersten Elektrode der beiden Elektroden des Ionenkondensators;
- Aufbringen (530) der Reservoirschicht, wobei die Reservoirschicht mit der Source-Elektrode und der Drain-Elektrode des Ionentransistors in Kontakt steht;
- Aufbringen (540) einer ionisch leitfähigen Schicht aus einem ionisch leitfähigen und dielektrischen Material und Strukturieren der ionisch leitfähigen Schicht, so dass ein erster Teil der ionisch leitfähigen Schicht und ein zweiter Teil der ionisch leitfähigen Schicht keinen Kontaktpunkt aufweisen, wobei der erste Teil die Reservoirschicht bedeckt und mit der Source-Elektrode und der Drain-Elektrode des Ionentransistors in Kontakt steht, wobei der zweite Teil zumindest teilweise die erste Elektrode des Ionenkondensators bedeckt;
- Aufbringen (550) einer zweiten Schicht aus elektrisch leitfähigem Material und Strukturierung der zweiten Schicht, so dass ein erster Teil der zweiten Schicht und ein zweiter Teil der zweiten Schicht ohne Kontaktpunkte erhalten werden, wobei der erste Teil der zweiten Schicht den ersten Teil der ionisch leitfähigen Schicht teilweise bedeckt und keinen Kontaktpunkt mit dem ersten Teil der ersten Schicht und dem zweiten Teil der ersten Schicht aufweist, wobei der zweite Teil der zweiten Schicht den zweiten Teil der ionisch leitfähigen Schicht zumindest teilweise bedeckt und keinen Kontaktpunkt mit dem zweiten Teil der ersten Schicht aufweist, wobei der erste Teil der zweiten Schicht der Gate-Elektrode des Ionentransistors entspricht, der zweite Teil der zweiten Schicht einer zweiten Elektrode der beiden Elektroden des Ionenkondensators entspricht, wobei sich die zweite Elektrode von der ersten Elektrode unterscheidet.

15. Herstellungsverfahren nach dem vorhergehenden Anspruch, bei dem das Aufbringen mindestens einer Schicht aus der ersten Schicht aus elektrisch leitfähigem Material, der ionisch leitfähigen Schicht und der zweiten Schicht aus elektrisch leitfähigem Material ein konformes Aufbringen ist.

16. Verfahren zur Speicherung von Ladungen unter Verwendung einer elektrochemischen Speichervorrichtung gemäß einem der Ansprüche 1 bis 10, umfassend:
- Anlegen (610) einer Spannung an die Gate-Elektrode des lonentransistors, um einen vordefinierten Leitfähigkeitswert für den Ionentransistor festzulegen;
- Erzeugen (620) eines zwischen dem lonentransistor und dem Ionenkondensator fließenden Stroms, wobei ein Wert der Ausgangsstromstärke des Ionentransistors einem Eingangswert des Eingangsstroms des Ionenkondensators entspricht.

## Claims

1. An electrochemical charge storage device (400) comprising an ionic transistor (410) and an ionic capacitor (420),
the ionic transistor (410) comprising:
- a layer (45) forming an ion reservoir, called reservoir layer;
- a source electrode (43a) in contact with a part of the reservoir layer (45);
- a drain electrode (43b) in contact with another part of the reservoir layer (45), the drain electrode (43b) and the source electrode (43a) being physically separated from each other, the source electrode (43a) and the drain electrode (43b) each being made of an electrically conductive material; and
- a gate electrode (47a) of an electrically conductive material, the gate electrode being separated from the reservoir layer by an ionic conductive layer (46a) of an ionic conductive and dielectric material, the ionic conductive layer (46a) being in contact with the source electrode (43a) and with the drain electrode (43b);
the ionic capacitor (420) comprising two electrodes (43b, 47b), each of the two electrodes (43b, 47b) being of an electrically conductive material, the ionic capacitor (420) comprising an ionic conductive layer (46b) separating the two electrodes (43b, 47b) from the ionic capacitor (420), the ionic conductive layer of the ionic capacitor (420) being of an ionic conductive and dielectric material;
wherein the ionic transistor (410) and the ionic capacitor (420) are electrically connected in series.

2. The device (400) according to claim 1, wherein the ionic conductive layer (46a) of the ionic transistor (410) and the ionic conductive layer (46b) of the ionic capacitor (420) are of a same ionic conductive and dielectric material.

3. The device (400) according to claim 2, wherein the ionic conductive and dielectric material is a lithium phosphorus oxynitride LiPON, a lithium silicon phosphorus oxynitride LiSiPON, a lithium germanium phosphorus sulphide LGPS, a lithium lanthanum zirconium oxide LiLaZrₓO_{y} or a lithium lanthanum tantalum oxide LiLaTaOₓ.

4. The device (400) according to one of the preceding claims, wherein the reservoir layer (45) and the ionic conductive layer (46a) of the ionic transistor are of a same ionic conductive and dielectric material.

5. The device (400) according to one of the preceding claims, wherein the ionic conductive layer (46a) of the ionic transistor and the ionic conductive layer (46b) of the ionic capacitor have a same thickness.

6. The device (400) according to one of the preceding claims, wherein the ionic transistor (410) and the ionic capacitor (420) are monolithically located on a same substrate (40, 41).

7. The device (400) according to claim 6, wherein the ionic transistor (410) and the ionic capacitor (420) are located on a same level of the substrate (40, 41).

8. The device (400) according to claim 6 or 7, wherein the substrate (40, 41) comprises a recess (42), wherein at least a part of the ionic capacitor (420) is housed in the recess (42).

9. The device (400) according to one of the preceding claims, wherein the source electrode (43a) of the ionic transistor, the drain electrode (43b) of the ionic transistor and one of the electrodes, referred to as the bottom electrode (43b), of the ionic capacitor are of a same electrically conductive material and have a same thickness.

10. The device (400) according to claim 9, wherein the bottom electrode (43b) of the ionic capacitor and one of the electrodes (43b) among the drain electrode and the source electrode of the ionic transistor are common.

11. A circuit comprising an electrochemical charge storage device (400) according to one of claims 1 to 10, the circuit further comprising a comparator block (38) connected in series with an output of the ionic capacitor (34), the comparator block (38) being configured to trigger a signal when a terminal voltage of the ionic capacitor (34) reaches a reference voltage value.

12. The circuit according to claim 11, wherein the comparator block (38) comprises an operational amplifier receiving on one input the terminal voltage of the ionic capacitor and on another input the reference voltage value, the signal being triggered when the terminal voltage of the ionic capacitor reaches the reference voltage value, the signal corresponding to a response of an artificial synapse.

13. The circuit according to claim 11 or 12, further comprising means for determining a time taken by the ionic capacitor (38) for its terminal voltage to reach the reference voltage.

14. A method for manufacturing an electrochemical charge storage device according to one of claims 1 to 10, the method successively comprising:
- depositing (520), onto a substrate, a first layer of electrically conductive material, and structuring said first layer so as to obtain a first part of the first layer and a second part of the first layer having no point of contact, the first part of the first layer corresponding to one of a source electrode and a gate electrode of the ionic transistor, the second part of the first layer corresponding to the other of the source electrode and the drain electrode of the ionic transistor and to a first electrode of the two electrodes of the ionic capacitor;
- depositing (530) the reservoir layer, the reservoir layer being in contact with the source electrode and drain electrode of the ionic transistor;
- depositing (540) an ionic conductive layer of an ionic conductive and dielectric material, and structuring the ionic conductive layer so as to obtain a first part of the ionic conductive layer and a second part of the ionic conductive layer having no point of contact, the first part covering the reservoir layer and being in contact with the source electrode and the drain electrode of the ionic transistor, the second part at least partially covering the first electrode of the ionic capacitor;
- depositing (550) a second layer of electrically conductive material, and structuring said second layer so as to obtain a first part of the second layer and a second part of the second layer having no point of contact, the first part of the second layer partially covering the first part of the ionic conductive layer and having no point of contact with the first part of the first layer and the second part of the first layer, the second part of the second layer at least partially covering the second part of the ionic conductive layer and having no point of contact with the second part of the first layer, the first part of the second layer corresponding to the gate electrode of the ionic transistor, the second part of the second layer corresponding to a second electrode of the two electrodes of the ionic capacitor, the second electrode being distinct from the first electrode.

15. The method for manufacturing according to the preceding claim, wherein the deposition of at least one of the first layer of electrically conductive material, the ionic conductive layer and the second layer of electrically conductive material is a conformal deposition.

16. A charge storage method using an electrochemical storage device according to one of claims 1 to 10, comprising:
- applying (610) a voltage at the gate electrode of the ionic transistor, so as to set a predefined conductance value for the ionic transistor;
- generating (620) a current flowing between the ionic transistor and the ionic capacitor, an intensity value of the output current of the ionic transistor corresponding to an input value of the input current of the ionic capacitor.
